# EUROPEAN PATENT APPLICATION

(11) **EP 4 811 590 A1**
(43) Date of publication of application: **23.09.2026**
(21) Application number: 26165785.2
(22) Date of filing: 18.03.2026
(51) Int. Cl.: H02J 3/32, H02J 7/34, H02J 7/82, H02J 7/92, H02J 9/06

(54) **ENERGY STORAGE STATE OF CHARGE TRACKING IN HIGH FREQUENCY CYCLING APPLICATION**

(30) Priority: 18.03.2025 US 202563773890 P; 04.02.2026 US 202619529732
(71) Applicant: Vertiv Corporation, Westerville, OH 43082 (US)
(72) Inventor: DIXON, William M., 43082 Westerville (US); GLOVER, Keith T., 43082 Westerville (US); KADAM, Krupal, 43082 Westerville (US)
(74) Representative: Beal, James Michael

(57) **Abstract**

A power management system may include a power converter to provide output power to one or more loads from at least one of a primary power source or a backup power source, where the power converter is operable in at least a power smoothing mode, and where the power converter in the power smoothing mode shields the primary power source from periodic load swings by periodically charging and discharging the backup power source to compensate for the periodic load swings. The system may further include a controller including one or more processors configured to execute program instructions causing the one or more processors to generate state of charge measurements of the backup power source in the power smoothing mode based on a weighted combination of two or more state of charge measurement techniques.

## Description

### CROSS-REFERENCE TO RELATED APPLICATIONS

The present application claims the benefit of U.S. Provisional Application No. 63/773,890 filed on March 18, 2025, and of U.S. Non-Provisional Application No. 19/529,732 filed on February 4, 2026.

### TECHNICAL FIELD

The present disclosure relates generally to state of charge tracking and, more particularly, to state of charge tracking when implementing power smoothing or other high-frequency cycling applications with batteries or capacitors.

### BACKGROUND

With the increasing use of GPU clusters in datacenters, there is a growing concern over large, repetitive load swings from these clusters. Traditional power smoothing methods using uninterruptible power supplies (UPS) or other power converters with batteries or capacitors (normal or supercapacitors) have proven insufficient in managing these load swings effectively. For example, rapid changes in the voltage and/or current make it difficult to accurately track the state of charge in the battery or capacitor. There is therefore a need to develop systems and methods to address the above deficiencies.

### SUMMARY

In embodiments, a power management system is provided. The power management system may include a power converter configured to provide output power to one or more loads from at least one of a primary power source or a backup power source. The power converter may be operable in at least a power smoothing mode. The power converter in the power smoothing mode may shield the primary power source from periodic load swings by periodically charging and discharging the backup power source to compensate for the periodic load swings. The power management system may further include a controller including one or more processors configured to execute program instructions causing the one or more processors to generate state of charge (SOC) measurements of the backup power source in the power smoothing mode based on a weighted combination of two or more SOC measurement techniques.

In embodiments, operation of the power converter in the power smoothing mode may be conditional on the SOC measurements of the backup power source having a value above a selected threshold based on the SOC measurements.

In embodiments, weights associated with the weighted combination may be dynamically generated using a weight-generating function based on at least one of a current or a voltage associated with the backup power source.

In embodiments, the two or more SOC measurement techniques may include an open-circuit voltage technique and a current coulomb-counting technique.

In embodiments, weights associated with the weighted combination may be dynamically generated using a weight-generating function based on at least one of a current or a voltage associated with the backup power source.

In embodiments, the weight-generating function may increasingly prioritize the current coulomb-counting technique as an absolute value of an actual current of the backup power source increases.

In embodiments, the SOC measurements may be calculated as *SOC* = (*K_{CC}*)(*SOC_{CC}*) *+* (*K_{OCV}*)(*SOC_{ocv}*)*. SOC_{CC}* may correspond to a SOC measurement using the current coulomb-counting technique. *SOC_{ocv}* may correspond to a SOC measurement using the open-circuit voltage technique. *K_{CC}* may correspond to a weight applied to the current coulomb-counting technique. *K_{ocv}* may correspond to a weight applied to the open-circuit voltage technique. The weight-generating function may include *K_{ocv}* = 1 - *K_{CC}* with ${K}_{CC} = min \left({\left|\frac{{I}_{act}}{{I}_{max}}\right|}^{0.1}, 1\right)$*. I_{act}* may be an actual current of the backup power source. *Iₘₐₓ* may correspond to a maximum current value.

In embodiments, the backup power source may include one or more batteries.

In embodiments, the backup power source may include one or more capacitors.

In embodiments, the one or more capacitors may include one or more supercapacitors.

In embodiments, the power management system may include an uninterruptible power supply (UPS).

In embodiments, the power converter may be further operable in a backup mode. The power converter in the backup mode may power the one or more loads with the backup power source.

In embodiments, a power management method is provided. The method may include providing output power to one or more loads using a power converter. The power converter may be configured to provide the output power to the one or more loads from at least one of a primary power source or a backup power source. The method may further include operating the power converter in a power smoothing mode. The power converter in the power smoothing mode may shield the primary power source from periodic load swings by periodically charging and discharging the backup power source to compensate for the periodic load swings. The method may further include generating SOC measurements of the backup power source in the power smoothing mode based on a weighted combination of two or more SOC measurement techniques.

In embodiments, operation of the power converter in the power smoothing mode may be conditional on a value of the SOC measurements of the backup power source being above a selected threshold based on the SOC measurements.

In embodiments, the method may further include operating the power converter in a backup mode when the value of the SOC measurements of the backup power source is lower than the selected threshold based on the SOC measurements. The power converter in the backup mode may power the one or more loads with the backup power source.

In embodiments, the method may further include dynamically generating weights associated with the weighted combination using a weight-generating function based on at least one of a current or a voltage associated with the backup power source.

In embodiments, the two or more SOC measurement techniques may include an open-circuit voltage technique and a current coulomb-counting technique.

In embodiments, weights associated with the weighted combination may be dynamically generated using a weight-generating function based on at least one of a current or a voltage associated with the backup power source. The weight-generating function may increasingly prioritize the current coulomb-counting technique as an absolute value of an actual current of the backup power source increases.

In embodiments, the SOC measurements may be calculated as *SOC* = (*K_{CC}*)(*SOC_{CC}*) *+* (*K_{OCV}*)(*SOC_{ocv}*)*. SOC_{CC}* may correspond to a SOC measurement using the current coulomb-counting technique. *SOC_{ocv}* may correspond to a SOC measurement using the open-circuit voltage technique. *K_{CC}* may correspond to a weight applied to the current coulomb-counting technique. *K_{ocv}* may correspond to a weight applied to the open-circuit voltage technique. The weight-generating function may include *K_{ocv}* = 1 - *K_{CC}* with ${K}_{CC} = min \left({\left|\frac{{I}_{act}}{{I}_{max}}\right|}^{0.1}, 1\right)$*. I_{act}* may be an actual current of the backup power source. *Iₘₐₓ* may correspond to a maximum current value.

In embodiments, the backup power source may include at least one of one or more batteries or one or more capacitors.

### BRIEF DESCRIPTION OF FIGURES

FIG. 1 is a block diagram of a power management system, in accordance with one or more embodiments of the present disclosure.
FIG. 2A illustrates a block diagram of the power management system with a power converter in a backup operational mode, in accordance with one or more embodiments of the present disclosure.
FIG. 2B illustrates a block diagram of the power management system with a power converter operating in a power smoothing mode, in accordance with one or more embodiments of the present disclosure.
FIG. 3A illustrates a plot of open-circuit voltage of a battery as a function of state of charge (SOC) percentage, in accordance with one or more embodiments of the present disclosure.
FIG. 3B illustrates a plot of current and SOC as a function of time, in accordance with one or more embodiments of the present disclosure.
FIG. 4A illustrates a simulated plot of current and voltage during power smoothing operation, in accordance with one or more embodiments of the present disclosure.
FIG. 4B illustrates a simulated plot of current and SOC as a function of time during power smoothing operation, in accordance with one or more embodiments of the present disclosure.
FIG. 4C illustrates a plot of open-circuit voltage versus SOC for a battery in charge and discharge cycles, in accordance with one or more embodiments of the present disclosure.
FIG. 5 illustrates a plot of SOC and current over time when using a weighted combination of SOC monitoring techniques, in accordance with one or more embodiments of the present disclosure.
FIG. 6 is a flow diagram of a method for SOC monitoring during power smoothing, in accordance with one or more embodiments of the present disclosure.

### DETAILED DESCRIPTION

Reference will now be made in detail to the subject matter disclosed, which is illustrated in the accompanying drawings. The present disclosure has been particularly shown and described with respect to certain embodiments and specific features thereof. The embodiments set forth herein are taken to be illustrative rather than limiting. It should be readily apparent to those of ordinary skill in the art that various changes and modifications in form and detail may be made without departing from the spirit and scope of the disclosure.

Embodiments of the present disclosure are directed to systems and methods providing state of charge (SOC) tracking of a backup power source associated with a power management system providing power smoothing of load fluctuations. As used herein, the SOC refers to the energy remaining in the backup power source, which may be provided as a percentage, a fraction, an energy value, or any other suitable form.

In some embodiments, a power management system includes a power converter to provide power to one or more loads based on a combination of a primary power source or a backup power source. The primary power source may provide power in the form of an alternating current (AC) or a direct current (DC) signal. Similarly, the output power to the one or more loads may be in the form of an AC signal or a DC signal. The backup power source may be any form of auxiliary power including, but not limited to, one or more batteries or one or more capacitors. In this way, the power converter may include, but is not limited to, an uninterruptible power supply (UPS).

In some embodiments, the power converter is operable in at least a power smoothing mode in which the power converter shields the primary power source from periodic load swings by periodically charging and discharging the backup power source. In some cases, the periodic charging and discharging may occur on a timeframe of milliseconds or shorter. In this way, the power draw from the primary power source may be constant or slowly varying within selected thresholds.

The power converter may further monitor the SOC of the backup battery using a weighted combination of multiple SOC techniques, where the weights are dynamically determined based on load conditions. In this way, the power converter may ensure a minimum SOC of the backup power source even in the presence of challenging high-frequency cycling conditions that may otherwise result in inaccurate SOC readings. Further, the weighted combination approach may be, but is not required to be implemented using existing battery management system (BMS) hardware without requiring sophisticated high-speed current sensing hardware or increased sampling rates.

A power converter as disclosed herein may be suitable for, but not limited to, providing power to loads such as GPUs or GPU clusters that induce repetitive load swings that may strain power distribution systems. For example, the power converter may rapidly charge and discharge power from the backup power source in the presence of load swings in order to reduce fluctuations of input AC power from an input power source.

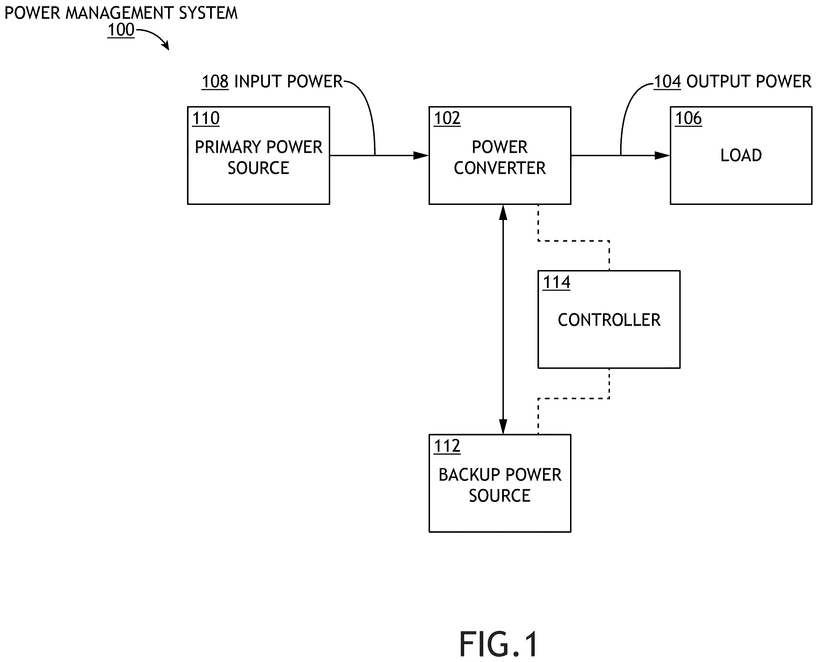

FIG. 1 is a block diagram of a power management system 100, in accordance with one or more embodiments of the present disclosure.

In some embodiments, the power management system 100 includes a power converter 102 to provide output power 104 to one or more loads 106 based on any combination of input power 108 from a primary power source 110 or a backup power source 112.

The power converter 102 may include any component or combination of components suitable for delivering the output power 104 to the load 106 from the primary power source 110 and/or backup power source 112. The power converter 102 may provide AC or DC power to the one or more loads 106 based on any combination of AC or DC input power 108. In this way, the power converter 102 may include an AC/AC converter, a DC/DC converter, a DC/AC converter, or an AC/DC converter. Further, the power converter 102 may be formed from any combination of passive or active components. For example, the power converter 102 may include switching transistors.

In some embodiments, the power converter 102 includes a rectifier to convert AC power to DC power and an inverter to generate the AC power from any source. For example, the power converter 102 may include a rectifier to convert AC input power 108 to DC power. This configuration may be suitable for, but is not limited to, utilizing a DC backup power source 112 (e.g., a battery, a capacitor, or the like), where the power converter 102 may provide output power 104 from any combination of the rectified input power 108 or DC power from the backup power source 112. In a case where the power converter 102 provides DC output power 104, the power converter 102 may include a DC/DC converter or other circuitry to provide the DC output power 104 from any combination of the rectified input power 108 or DC power from the backup power source 112. In a case where the power converter 102 provides AC output power 104, the power converter 102 may include an inverter (e.g., DC/AC converter) to generate the AC output power 104 from any combination of the rectified input power 108 or DC power from the backup power source 112. However, this is merely an illustration and not limiting on the scope of the present disclosure.

In some embodiments, the power converter 102 includes a bypass that may selectively provide the output power 104 directly from the input power 108 without AC/DC and DC/AC conversion using the rectifier and the inverter.

The backup power source 112 may include any power source providing DC or AC power. In some embodiments, the backup power source 112 includes a DC power source such as, but not limited to, a battery or a capacitor. In the case of a capacitor, the backup power source 112 may include one or more traditional capacitors or one or more supercapacitors. Further, the backup power source 112 may be a component of the power converter 102 or provided as an external component as shown in FIG. 1.

In some embodiments, the power converter 102 provides power smoothing. For example, the power converter 102 may be operable in at least a power smoothing mode. In this configuration, the power converter 102 dynamically charges and discharges the backup power source 112 in response to load swings in order to reduce or eliminate load swings on the input power 108. In this way, the power converter 102 may shield the primary power source 110 from the load swings. In some embodiments, the power converter 102 continuously provides power smoothing regardless of the power draw of the load 106.

In some embodiments, the power converter 102 is operable in multiple modes, where at least one mode is a power smoothing mode. In this configuration, the power converter 102 may selectively provide power smoothing when desired, but may operate in other modes when power smoothing is not desired or necessary. For example, an additional mode may include a backup mode in which the backup power source 112 is utilized only when the input power 108 is inadequate (e.g., lower than a selected threshold).

In some embodiments, the power management system 100 includes a controller 114 to generate SOC measurements. For example, the controller 114 may generate SOC measurements during at least power smoothing operation. The controller 114 may include one or more processors configured to execute program instructions stored on a memory (e.g., a non-volatile memory). The one or more processors may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more processors may include any device configured to execute algorithms and/or instructions (e.g., program instructions stored in memory). The memory may include any storage medium known in the art suitable for storing program instructions executable by the associated one or more processors. For example, the memory may include a non-transitory memory medium. By way of another example, the memory may include, but is not limited to, a read-only memory (ROM), a random-access memory (RAM), a magnetic or optical memory device (e.g., disk), a magnetic tape, a solid-state drive and the like.

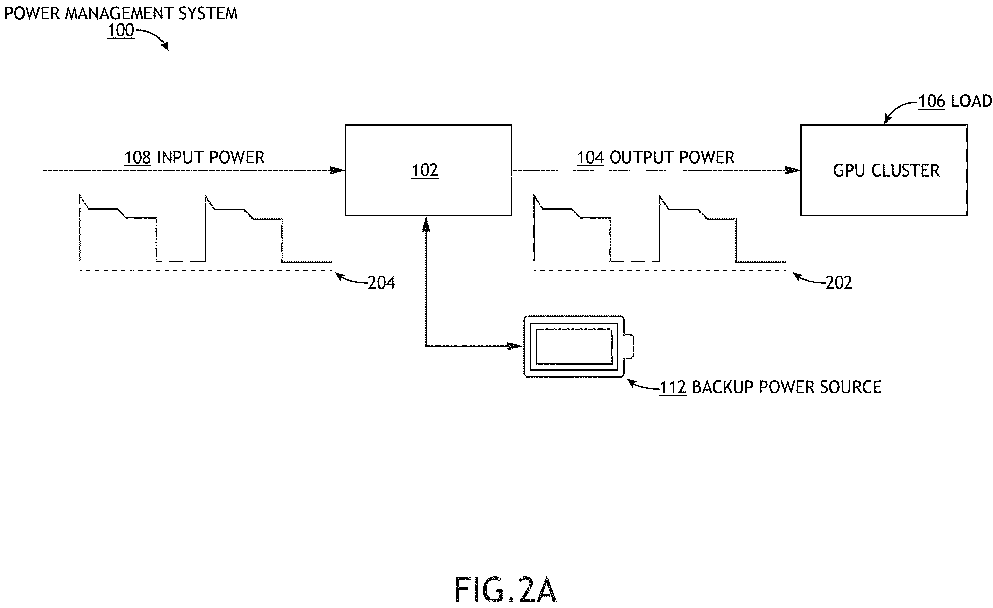

FIGS. 2A-2B illustrate power smoothing by the power converter 102, in accordance with one or more embodiments of the present disclosure.

FIG. 2A illustrates a block diagram of a power converter 102 in a backup operational mode, in accordance with one or more embodiments of the present disclosure. In this configuration, load swings 202 generated by the load 106 (e.g., a GPU cluster, or any other load) may require rapid swings in input current 204 associated with the input power 108. However, such rapid swings may undesirably strain the primary power source 110.

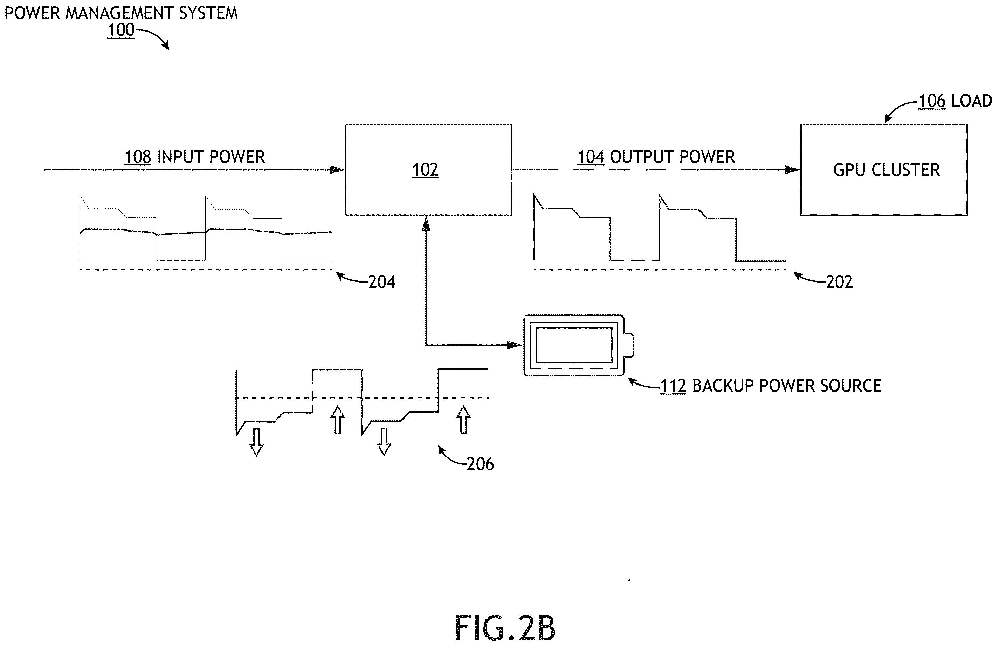

FIG. 2B illustrates a block diagram of a power converter 102 in a power smoothing mode, in accordance with one or more embodiments of the present disclosure. In this configuration, the power converter 102 dynamically charges and discharges the backup power source 112 to reduce the current variation of the input power 108. For example, FIG. 2B illustrates a backup power signal 206 from the backup power source 112 to provide power smoothing, where the backup power signal 206 includes rapid variations to compensate for the load swings 202. In this way, the power converter 102 may protect or shield the primary power source 110 from the load swings 202.

It is contemplated herein that rapid variations in the backup power signal 206 may impact the ability to accurately monitor the SOC of the backup power source 112. Accurate monitoring of the SOC of the backup power source 112 may be useful for various purposes including, but not limited to, ensuring a minimum SOC. For instance, a minimum SOC may be needed to ensure reliable operation in a backup mode where the input power 108 is insufficient to meet the power demands of the load 106.

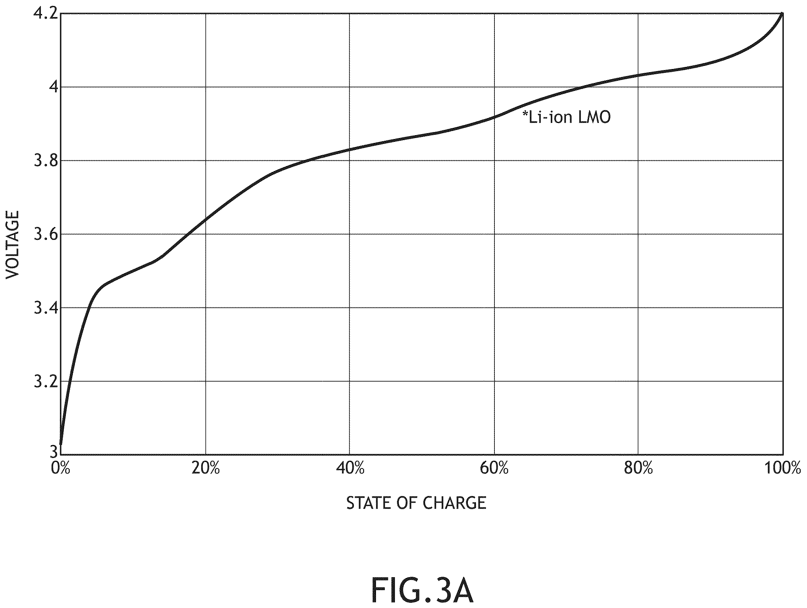

FIGS. 3A-4C depict various plots that illustrate the challenges of monitoring the SOC during high-frequency cycling.

In a general sense, SOC may be measured based on voltage and/or current measurements of the backup power source 112. Further, the SOC may be relatively easily monitored when the backup power source 112 is resting or in a continuous charge/discharge cycle.

For example, the SOC may be measured using an open-circuit voltage technique in which a measurement of the SOC is determined based on a measurement of the voltage across a backup power source 112. FIG. 3A illustrates a plot of open-circuit voltage of a battery (e.g., a backup power source 112) as a function of the SOC percentage, in accordance with one or more embodiments of the present disclosure. In particular, FIG. 3A is representative of a Li-ion LMO battery. As shown in FIG. 3A, the open-circuit voltage may be a generally monotonically increasing function of the SOC such that a measurement of the open-circuit voltage is sufficient to determine the SOC. In some cases, the relationship between open-circuit voltage and SOC may vary with temperature. For example, the plot in FIG. 3A may shift or change shape at different temperatures. Accordingly, the SOC may be determined based on measurement of voltage and/or temperature using the open-circuit voltage technique, where temperature measurements may be used in in some cases along with voltage measurements to provide additional accuracy.

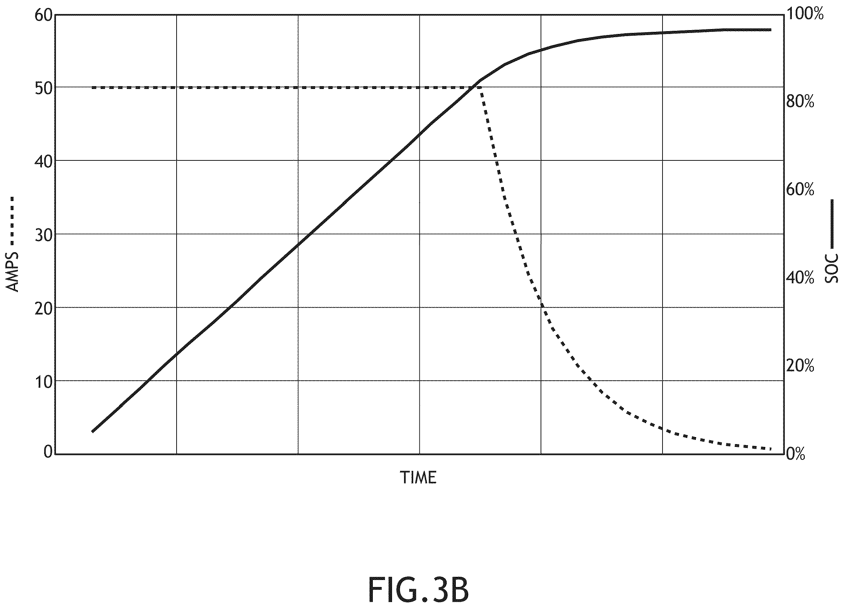

As another example, the SOC may be measured using a current coulomb-counting technique in which a measurement of the SOC is determined based on measurements of current to or from the backup power source 112 over time. FIG. 3B illustrates a plot of current and SOC as a function of time, in accordance with one or more embodiments of the present disclosure. In particular, FIG. 3B illustrates a constant charging configuration. In FIG. 3B, the backup power source 112 is charged by applying a constant current until a certain SOC is reached (here, 80%) and then tapering the current to gradually reach a desired SOC level. In this case, the SOC may be calculated by tracking on the input current and associated input energy over time.

However, it is further contemplated herein that high-frequency cycling conditions such as those associated with power smoothing operation may present challenges for the monitoring of the SOC of the backup power source 112 through simple application of the open-circuit voltage technique and/or the current coulomb-counting technique.

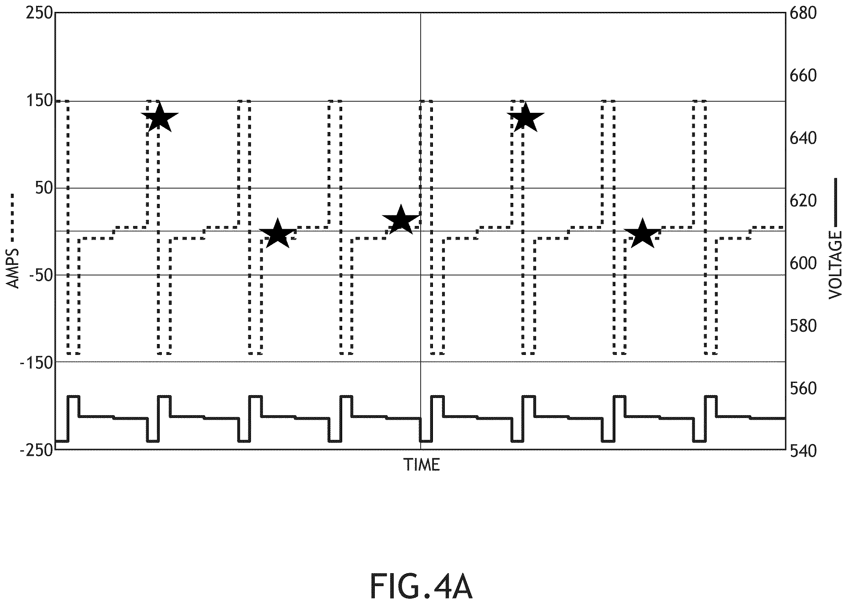

FIG. 4A illustrates a simulated plot of current and voltage during power smoothing operation, in accordance with one or more embodiments of the present disclosure. In FIG. 4A, both the current and the voltage undergo rapid variations that present difficulties for straightforward implementation of SOC monitoring using either the open-circuit voltage technique or the current coulomb-counting technique.

For example, a current sampling rate of a typical power converter 102 may be too slow to track rapid changes in the current during a power smoothing operation, which may lead to aliasing and inaccurate SOC measurements. In some cases, the power smoothing operations and/or the sampling rate may be on the order of milliseconds, though this is merely an illustration. In FIG. 4A, the star symbols represent sampling times that are inadequate to capture the current variations in a particular application and may thus be inadequate for monitoring the SOC using the current coulomb-counting technique.

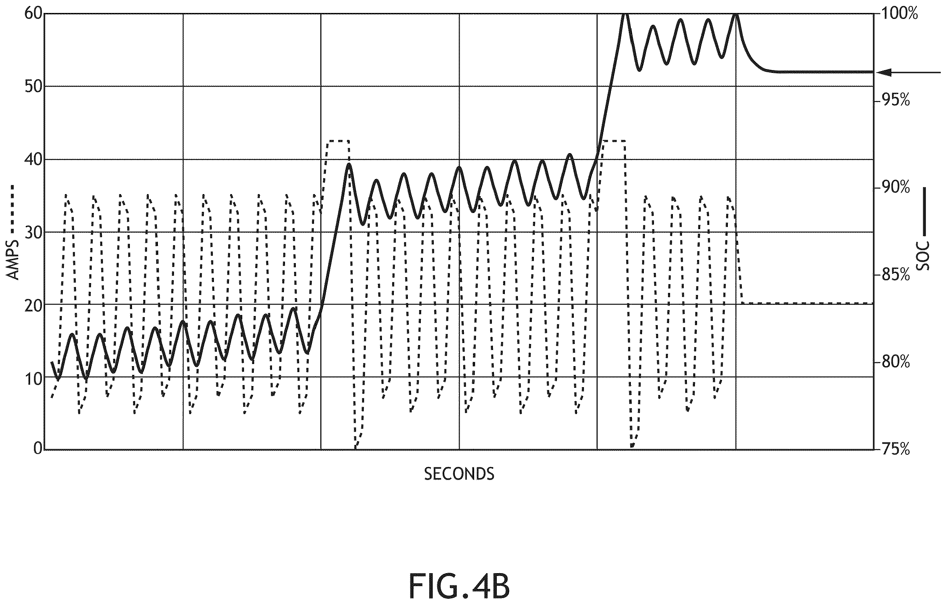

Errors in a SOC calculation using the current coulomb-counting technique in a case of rapidly-varying current are further depicted in FIG. 4B. FIG. 4B illustrates a simulated plot of current over time as well as a SOC calculation based on inadequate sampling of the current, in accordance with one or more embodiments of the present disclosure. As shown in FIG. 4B, the inadequate sampling rate results in cumulative errors in the SOC calculation, which are exacerbated by complex variations in the current signal.

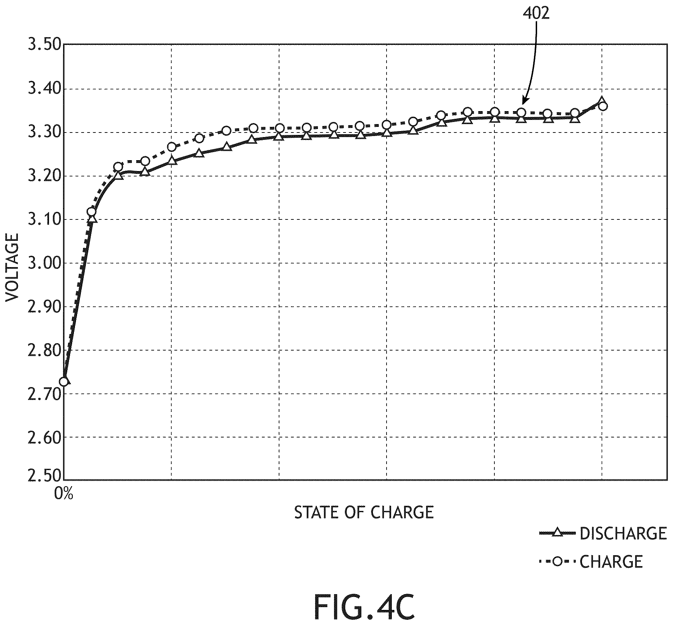

Referring now to FIGS. 4A and 4C, it is noted that calculations of the SOC using the open-circuit voltage technique alone may also present challenges. For example, the rapidly-varying voltage may also suffer from aliasing caused by insufficient sampling. Voltage versus SOC curve of certain battery types may also have ambiguities that complicate SOC calculations in the presence of fluctuating voltages. FIG. 4C illustrates a plot of voltage versus SOC for a Li-ion LFP battery in both charge and discharge cycles, in accordance with one or more embodiments of the present disclosure. Li-ion LFP batteries may be particularly challenging for SOC monitoring during high-frequency cycling applications such as power smoothing due to their ambiguous SOC versus voltage characteristics, which may compound the difficulty of accurate SOC tracking. As an illustration, the voltage versus SOC plot may include relatively flat regions (e.g., region 402) where the voltage is relatively constant for a range of SOC values. As another illustration, the voltage associated with a particular SOC level may vary depending on whether the backup power source 112 is in a charging cycle or a discharging cycle. Additionally, the voltage may not be a reliable indicator of SOC when current is flowing. However, it is to be understood that the SOC tracking as disclosed herein may be applied to any batter type including, but not limited to, Li-ion LFP batteries.

In some embodiments, the power converter 102 calculates SOC based on a weighted combination of multiple techniques such as, but not limited to, the open-circuit voltage technique and the current coulomb-counting technique. This approach may be suitable for high-frequency cycling conditions such as, but not limited to, power smoothing operations and/or sampling times on the order of milliseconds or shorter. Further, this approach may be, but is not required to be, suitable for implementation with existing battery management system hardware without requiring hardware modifications or sophisticated high-speed current sensing equipment. In some embodiments, the power converter 102 includes dedicated hardware such as, but not limited to, high-speed current sensors, dedicated processing units, or specialized analog-to-digital converters configured to support the weighted combination of SOC measurement techniques. The weights of this combination may be dynamically determined based the load conditions. Put another way the weights may be dynamically determined based on a dynamic evaluation of the trustworthiness of each measurement technique.

Equation (1) depicts a weighted SOC measurement, in accordance with one or more embodiments of the present disclosure. $SOC = \left({K}_{CC}\right) \left({SOC}_{CC}\right) + \left({K}_{OCV}\right) \left({SOC}_{ocv}\right) .$ In Equation (1), *SOC_{CC}* corresponds to a SOC measurement using the current coulomb-counting technique and *SOC_{ocv}* corresponds to a SOC measurement using the open-circuit voltage technique. Further, *K_{CC}* and *K_{ocv}* correspond to weights for the coulomb-counting technique and the open-circuit voltage technique, respectively.

The weights (e.g., *K_{CC}* and *K_{ocv}* here) may be determined using any technique including, but not limited to, a weight-generating function. In some embodiments, the weights are dynamically determined based on a value of the current at a given time. For example, Equations (2)-(3) depict one non-limiting example of dynamic weight calculations using weight-generating functions: ${K}_{CC} = min \left({\left|\frac{{I}_{act}}{{I}_{max}}\right|}^{0.1}, 1\right)$ ${K}_{ocv} = 1 - {K}_{CC} .$ In this configuration, Equation (3) ensures that the weights add to unity and equation (2) assigns weights based on a comparison of an actual current at a given time (*I_{act}*) with a maximum current value (*Iₘₐₓ*), where the maximum current value may correspond to a limitation of the backup power source 112 (e.g., a maximum charge or discharge current) or simply a value selected to provide a desired stability in the SOC calculation. The particular non-limiting example of Equation (2) provides weights that favor (e.g., prioritize) the open-circuit voltage technique when the actual current is near zero and increasingly favors the current coulomb-counting technique as the actual value (or an absolute value of an actual value) of the current increases. In particular, the open-circuit voltage technique is exclusively used (*K_{CC}* = 0, *K_{ocv}* = 1) when the actual current is zero and the current coulomb-counting technique is exclusively used (*K_{CC}* = 1, *K_{ocv}* = 0) when the actual current is equal to or greater than the maximum current. Further, the power of exponent (shown as 0.1 in Equation (2)) controls the balance between the two techniques for intermediate actual current values.

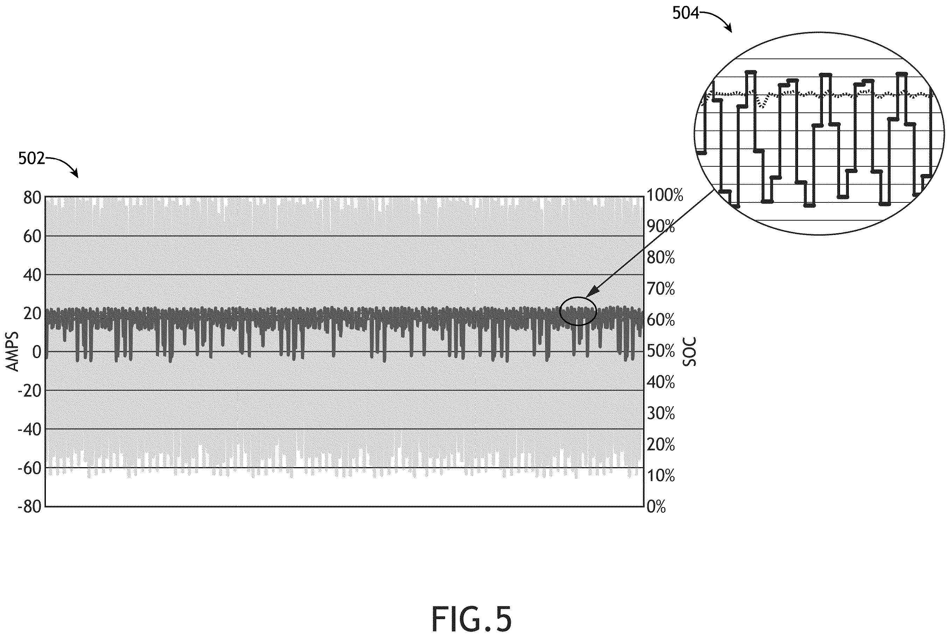

FIG. 5 illustrates a plot 502 of SOC and current over time when using a weighted combination of the voltage-based and current-based SOC monitoring techniques, in accordance with one or more embodiments of the present disclosure. For example, FIG. 5 depicts a plot 502 of SOC and current over time when using a weighted combination of the open-circuit voltage and current coulomb-counting techniques disclosed herein. The inset 504 in FIG. 5 depicts a magnified view of a representative portion of the plot 502. As shown in FIG. 5, the SOC values are accurately tracked even in the presence of rapid current fluctuations.

However, it is to be understood that Equations (1)-(3) are provided solely for illustrative purposes and should not be interpreted as limiting the present disclosure. Rather, any weighting scheme suitable for monitoring SOC within selected performance metrics is within the spirit and scope of the present disclosure.

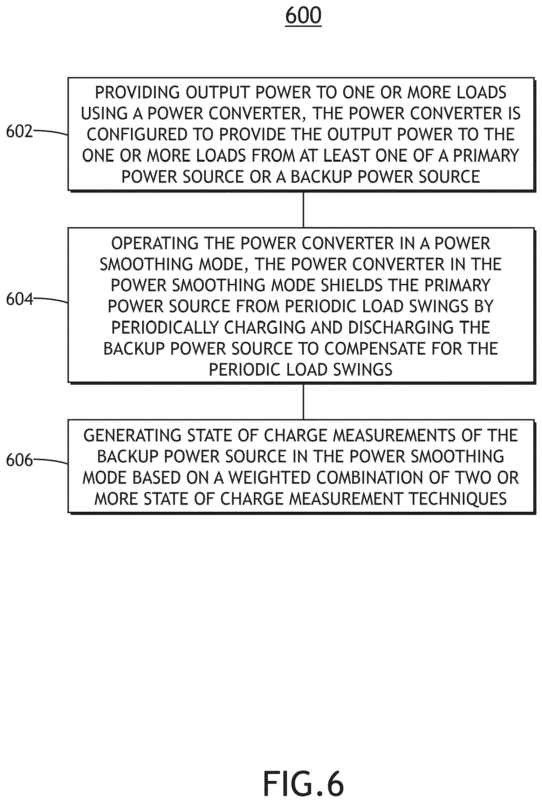

FIG. 6 is a flow diagram illustrating steps performed in a method 600 for SOC monitoring during power smoothing, in accordance with one or more embodiments of the present disclosure. Applicant notes that the embodiments and enabling technologies described previously herein in the context of the power management system 100 should be interpreted to extend to method 600. For example, the controller 114 may implement directly or indirectly (e.g., via program instructions) any of the steps of the method 600. It is further noted, however, that the method 600 is not limited to the architecture of the power management system 100.

In some embodiments, the method 600 includes a step 602 of providing output power to one or more loads using a power converter, where the power converter is configured to provide the output power to the one or more loads from at least one of a primary power source or a backup power source. In some embodiments, the method 600 includes a step 604 of operating the power converter in a power smoothing mode, where the power converter in the power smoothing mode shields the primary power source from periodic load swings by periodically charging and discharging the backup power source to compensate for the periodic load swings. In some embodiments, the method 600 includes a step 606 of generating state of charge measurements of the backup power source in the power smoothing mode based on a weighted combination of two or more state of charge measurement techniques

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.
The disclosure comprises the following items:
1. A power management system, comprising:
   a power converter configured to provide output power to one or more loads from at least one of a primary power source or a backup power source, wherein the power converter is operable in at least a power smoothing mode, wherein the power converter in the power smoothing mode shields the primary power source from periodic load swings by periodically charging and discharging the backup power source to compensate for the periodic load swings; and
   a controller including one or more processors configured to execute program instructions causing the one or more processors to generate state of charge measurements of the backup power source in the power smoothing mode based on a weighted combination of two or more state of charge measurement techniques.
2. The power management system of item 1, wherein operation of the power converter in the power smoothing mode is conditional on the state of charge measurements of the backup power source having a value above a selected threshold based on the state of charge measurements.
3. The power management system of item 1 or item 2, wherein weights associated with the weighted combination are dynamically generated using a weight-generating function based on at least one of a current or a voltage associated with the backup power source.
4. The power management system of any preceding item, wherein the two or more state of charge measurement techniques comprise:
   an open-circuit voltage technique; and
   a current coulomb-counting technique.
5. The power management system of any preceding item, wherein weights associated with the weighted combination are dynamically generated using a weight-generating function based on at least one of a current or a voltage associated with the backup power source.
6. The power management system of any preceding item, wherein the weight-generating function increasingly prioritizes the current coulomb-counting technique as an absolute value of an actual current of the backup power source increases.
7. The power management system of any preceding item, wherein the state of charge measurements (SOC) are calculated as *SOC* = (*K_{CC}*)(*SOC_{CC}*) *+* (*K_{OCV}*)(*SOC_{ocv}*)*,* wherein *SOC_{CC}* corresponds to a SOC measurement using the current coulomb-counting technique, wherein *SOC_{ocv}* corresponds to a SOC measurement using the open-circuit voltage technique, wherein *K_{CC}* corresponds to a weight applied to the current coulomb-counting technique, wherein *K_{ocv}* corresponds to a weight applied to the open-circuit voltage technique, wherein the weight-generating function comprises *K_{ocv}* = 1 *- K_{CC}* with ${K}_{CC} = min \left({\left|\frac{{I}_{act}}{{I}_{max}}\right|}^{0.1}, 1\right)$*,* wherein *I_{act}* is an actual current of the backup power source, wherein *Iₘₐₓ* corresponds to a maximum current value.
8. The power management system of any preceding item, wherein the backup power source comprises:
   one or more batteries.
9. The power management system of any preceding item, wherein the backup power source comprises:
   one or more capacitors.
10. The power management system of any preceding item, wherein the one or more capacitors comprise:
   one or more supercapacitors.
11. The power management system of any preceding item, wherein the power management system comprises:
   an uninterruptible power supply.
12. The power management system of any preceding item, wherein the power converter is further operable in a backup mode, wherein the power converter in the backup mode powers the one or more loads with the backup power source.
13. A power management method, comprising:
   providing output power to one or more loads using a power converter, wherein the power converter is configured to provide the output power to the one or more loads from at least one of a primary power source or a backup power source;
   operating the power converter in a power smoothing mode, wherein the power converter in the power smoothing mode shields the primary power source from periodic load swings by periodically charging and discharging the backup power source to compensate for the periodic load swings; and
   generating state of charge measurements of the backup power source in the power smoothing mode based on a weighted combination of two or more state of charge measurement techniques.
14. The power management method of item 13, wherein operation of the power converter in the power smoothing mode is conditional on a value of the state of charge measurements of the backup power source being above a selected threshold based on the state of charge measurements.
15. The power management method of item 13 or item 14, further comprising:
   operating the power converter in a backup mode when the value of the state of charge measurements of the backup power source is lower than the selected threshold based on the state of charge measurements, wherein the power converter in the backup mode powers the one or more loads with the backup power source.
16. The power management method of any of items 13-15, further comprising:
   dynamically generating weights associated with the weighted combination using a weight-generating function based on at least one of a current or a voltage associated with the backup power source.
17. The power management method of any of items 13-16, wherein the two or more state of charge measurement techniques comprise:
   an open-circuit voltage technique; and
   a current coulomb-counting technique.
18. The power management method of any of items 13-17, wherein weights associated with the weighted combination are dynamically generated using a weight-generating function based on at least one of a current or a voltage associated with the backup power source, wherein the weight-generating function increasingly prioritizes the current coulomb-counting technique as an absolute value of an actual current of the backup power source increases.
19. The power management method of any of items 13-18, wherein the state of charge measurements (SOC) are calculated as *SOC* = (*K_{CC}*)(*SOC_{CC}*) *+* (*K_{OCV}*)(*SOC_{ocv}*)*,* wherein *SOC_{CC}* corresponds to a SOC measurement using the current coulomb-counting technique, wherein *SOC_{ocv}* corresponds to a SOC measurement using the open-circuit voltage technique, wherein *K_{CC}* corresponds to a weight applied to the current coulomb-counting technique, wherein *K_{ocv}* corresponds to a weight applied to the open-circuit voltage technique, wherein the weight-generating function comprises *K_{ocv}* = 1 *- K_{CC}* with ${K}_{CC} = min \left({\left|\frac{{I}_{act}}{{I}_{max}}\right|}^{0.1}, 1\right)$*,* wherein *I_{act}* is an actual current of the backup power source, wherein *Iₘₐₓ* corresponds to a maximum current value.
20. The power management method of any of items 13-19, wherein the backup power source comprises:
   at least one of one or more batteries or one or more capacitors.

## Claims

1. A power management system, comprising:
a power converter configured to provide output power to one or more loads from at least one of a primary power source or a backup power source, wherein the power converter is operable in at least a power smoothing mode, wherein the power converter in the power smoothing mode shields the primary power source from periodic load swings by periodically charging and discharging the backup power source to compensate for the periodic load swings; and
a controller including one or more processors configured to execute program instructions causing the one or more processors to generate state of charge measurements of the backup power source in the power smoothing mode based on a weighted combination of two or more state of charge measurement techniques.

2. The power management system of claim 1, wherein operation of the power converter in the power smoothing mode is conditional on the state of charge measurements of the backup power source having a value above a selected threshold based on the state of charge measurements.

3. The power management system of claim 1 or claim 2, wherein weights associated with the weighted combination are dynamically generated using a weight-generating function based on at least one of a current or a voltage associated with the backup power source.

4. The power management system of any preceding claim, wherein the two or more state of charge measurement techniques comprise:
an open-circuit voltage technique; and
a current coulomb-counting technique.

5. The power management system of claim 4, wherein the weight-generating function increasingly prioritizes the current coulomb-counting technique as an absolute value of an actual current of the backup power source increases.

6. The power management system of claim 4 or claim 5, wherein the state of charge measurements, "SOC", are calculated as *SOC* = (*K_{CC}*)(*SOC_{CC}*) *+* (*K_{OCV}*)(*SOC_{ocv}*)*,* wherein *SOC_{CC}* corresponds to a SOC measurement using the current coulomb-counting technique, wherein *SOC_{ocv}* corresponds to a SOC measurement using the open-circuit voltage technique, wherein *K_{CC}* corresponds to a weight applied to the current coulomb-counting technique, wherein *K_{ocv}* corresponds to a weight applied to the open-circuit voltage technique, wherein the weight-generating function comprises *K_{ocv}* = 1 *- K_{CC}* with ${K}_{CC} = min \left({\left|\frac{{I}_{act}}{{I}_{max}}\right|}^{0.1}, 1\right)$*,* wherein *I_{act}* is an actual current of the backup power source, wherein *Iₘₐₓ* corresponds to a maximum current value.

7. The power management system of any preceding claim, wherein the backup power source comprises:
one or more batteries, one or more capacitors and/or one or more supercapacitors.

8. The power management system of any preceding claim, wherein the power management system comprises:
an uninterruptible power supply.

9. The power management system of any preceding claim 1, wherein the power converter is further operable in a backup mode, wherein the power converter in the backup mode powers the one or more loads with the backup power source.

10. A power management method, comprising:
providing output power to one or more loads using a power converter, wherein the power converter is configured to provide the output power to the one or more loads from at least one of a primary power source or a backup power source;
operating the power converter in a power smoothing mode, wherein the power converter in the power smoothing mode shields the primary power source from periodic load swings by periodically charging and discharging the backup power source to compensate for the periodic load swings; and
generating state of charge measurements of the backup power source in the power smoothing mode based on a weighted combination of two or more state of charge measurement techniques.

11. The power management method of claim 10, wherein operation of the power converter in the power smoothing mode is conditional on a value of the state of charge measurements of the backup power source being above a selected threshold based on the state of charge measurements, and optionally the method further comprising:
operating the power converter in a backup mode when the value of the state of charge measurements of the backup power source is lower than the selected threshold based on the state of charge measurements, wherein the power converter in the backup mode powers the one or more loads with the backup power source.

12. The power management method of claim 10 or claim 11, further comprising:
dynamically generating weights associated with the weighted combination using a weight-generating function based on at least one of a current or a voltage associated with the backup power source.

13. The power management method of claim 13, wherein the two or more state of charge measurement techniques comprise:
an open-circuit voltage technique; and
a current coulomb-counting technique, and optionally:
wherein weights associated with the weighted combination are dynamically generated using a weight-generating function based on at least one of a current or a voltage associated with the backup power source, wherein the weight-generating function increasingly prioritizes the current coulomb-counting technique as an absolute value of an actual current of the backup power source increases.

14. The power management method of claim 13, wherein the state of charge measurements (SOC) are calculated as *SOC* = (*K_{CC}*)(*SOC_{CC}*) *+* (*K_{OCV}*)(*SOC_{ocv}*)*,* wherein *SOC_{CC}* corresponds to a SOC measurement using the current coulomb-counting technique, wherein *SOC_{ocv}* corresponds to a SOC measurement using the open-circuit voltage technique, wherein *K_{CC}* corresponds to a weight applied to the current coulomb-counting technique, wherein *K_{ocv}* corresponds to a weight applied to the open-circuit voltage technique, wherein the weight-generating function comprises *K_{ocv}* = 1 *- K_{CC}* with ${K}_{CC} = min \left({\left|\frac{{I}_{act}}{{I}_{max}}\right|}^{0.1}, 1\right)$*,* wherein *I_{act}* is an actual current of the backup power source, wherein *Iₘₐₓ* corresponds to a maximum current value.

15. The power management method of any of claims 10-14, wherein the backup power source comprises:
at least one of one or more batteries or one or more capacitors.
